Europäisches Patentamt

European Patent Office

Office européen des brevets

(19)

(11) Veröffentlichungsnummer: **0 495 195 A2**

# (12) EUROPÄISCHE PATENTANMELDUNG

(21) Anmeldenummer: **91120945.0**

(22) Anmeldetag: **06.12.91**

(51) Int. Cl.⁵: **H03M 1/06**, H03M 1/82

(30) Priorität: **17.01.91 DE 4101193**

(43) Veröffentlichungstag der Anmeldung:
**22.07.92 Patentblatt 92/30**

(84) Benannte Vertragsstaaten:
**BE CH GB LI**

(71) Anmelder: **FRIEDRICH MERK-TELEFONBAU GMBH**
**Rosenheimer Strasse 139**
**W-8000 München 80(DE)**

(72) Erfinder: **Woyda-Wolf, Martin, Dipl.-Ing.**
**St. Cajetan Strasse 6**
**W-8000 München 80(DE)**

(54) **Verfahren zum Betrieb eines Digital-Analog-Wandlers.**

(57) 2.1 Es soll eine preiswerte und relativ genaue Digital-Analog-Wandlung erreicht werden, wobei mit einem geringen Aufwand von Bauelementen deren Toleranzen zur Ermittlungs des Meßergebnisses unerheblich sind. Die zur Durchführung des Verfahrens notwendigen Komponenten sollen in einer integrierten Schaltung zusammengefaßt werden können, welche einen geringen Stromverbrauch aufweist.

2.2 In einer Referenzmeßphase wird ermittelt, wieviele Zählschritte notwendig sind, um einen Schalter so oft oder so lange zu schließen, bis ein Kondensator auf den Wert der Referenzspannung aufgeladen ist. Die so ermittelte Schrittzahl wird einer Berechnung zugrunde gelegt, wobei unter Berücksichtigung des digitalen Maximalwertes und des aus der Referenzspannung sich ergebenden Teilerverhältnisses zur Maximalspannung aus dem zu wandelnden Digitalwert die Schrittzahl eines Zählers ermittelt wird, mit der dann in einer Meßphase der Schalter zur Aufladung des Kondensators auf die analoge Ausgangsspannung angesteuert werden muß.

2.3 Bei der Erzeugung der analogen Meßgröße gehen die Toleranzen der dazu notwendigen Ströme und Spannungen sowie die Toleranzen der beteiligten Bauelemente, z. B. Kapazitäten und Widerstände der beteiligten Bauelemente nicht in die Rechnung ein. Da jeweils unmittelbar vor einer Meßphase eine Referenzmeßphase durchgeführt wird, können auch Änderungen von elektrischen Werten keinen Einfluß auf die Größe der analogen Ausgangsspannung haben.

EP 0 495 195 A2

Die Erfindung betrifft ein Verfahren zum Betrieb eines Digital-Analog-Wandlers nach dem Oberbegriff des Patentanspruchs 1.

Aus der DE-PS 12 96 181 ist ein Decodierer für Puls-Code-Modulationsanlagen bekannt. Dieser Decodierer erzeugt aus einem empfangenen digitalen Codewort eine Amplitude, deren Höhe dem Wert des empfangenen Codewortes entspricht. Zu diesem Zweck ist ein Stromspeicherelement (Kondensator) vorgesehen, welches über eine Stromquelle aufgeladen wird. Die Höhe dieser Kondensatoraufladung ist abhängig von einem Zählvorgang, dessen Dauer von der Wertigkeit des empfangenen Codewortes bestimmt wird. Weil bei der Puls-Code-Modulation ein nicht-linearer Code vorliegt, womit eine Komprimierung des Signals erreicht wird, sind bei diesem Decodierer Stromquellen mit verschiedenen Stromstärken vorgesehen. Ein derartiger Decodierer ist speziell für die Umwandlung von Puls-Code-Modulationssignalen (PCM) in jeweils entsprechende Puls-Amplituden-Modulations-Signale (PAM) ausgelegt.

Die Genauigkeit bei der Ermittlung des Analogsignals spielt bei dieser Anwendung keine große Rolle, weil der auszugebende Pegel durch Dämpfung oder Verstärkung den Anforderungen entsprechend angepaßt werden kann. Für die Übermittlung von Meßergebnissen, wobei es auf eine hohe, von den Toleranzen der Bauelemente unabhängige Genauigkeit ankommt, ist ein derartiger Decodierer, bzw. Digital-Analog-Wandler nur bedingt geeignet.

Ausgehend vom vorgenannten Stand der Technik besteht die Aufgabe der Erfindung darin, ein Verfahren für den Betrieb eines Digital-Analog-Wandlers anzugeben, bei dem mit einem geringen Aufwand von Bauelementen, deren Toleranzen zur Ermittlung des Meßergebnisses unerheblich sind, eine preiswerte und relativ genaue Digital-Analog-Wandlung erreicht werden kann. Es soll außerdem erreicht werden, daß die zur Durchführung des Verfahrens notwendigen Komponenten in einer integrierten Schaltung zusammengefaßt werden können, welche einen geringen Stromverbrauch aufweist.

Zur Lösung dieser Aufgabe ist eine Merkmalskombination vorgesehen, wie sie im Patentanspruch 1 angegeben ist.

Damit wird in vorteilhafter Weise erreicht, daß bei der Erzeugung der analogen Meßgröße die Toleranzen der dazu notwendigen Ströme und Spannungen sowie die Toleranzen der beteiligten Bauelemente völlig bedeutungslos sind. Weil jeweils unmittelbar vor einer Meßphase eine Referenzmeßphase durchgeführt wird, können auch durch Alterung oder sonstige Einflüsse bedingte Änderungen der elektrischen Werte keinen Einfluß auf die Größe der analogen Ausgangsspannung haben.

Vorteilhafte Weiterbildungen der Erfindung sind in den Unteransprüchen angegeben.

Ein Ausführungsbeispiel der Erfindung wird nachfolgend anhand einer Zeichnung näher erläutert. Es sei angenommen, daß ein Digitalwert, der über den Digitaleingang DE in die Steuereinrichtung SE gelangt ist, zu einem Analogwert gewandelt werden soll, welcher am Analogausgang Aa zu erscheinen hat. Die Erzeugung eines Analogwertes geschieht dadurch, daß ein Kondensator C über eine Konstantstromquelle KQ linear aufgeladen wird. Zu diesem Zweck dient ein Schalter S1, welcher für eine vorbestimmte Dauer oder durch eine feststehende Anzahl kleinerer gleichlanger Zeitabschnitte geschlossen wird.

Beim Beginn einer Messung wird zunächst dafür gesorgt, daß der Kondensator C entladen ist. Zu diesem Zweck kann ein Schalter S2 angesteuert werden, welcher den Kondensator C kurzschließt. Zu Beginn einer Messung wird jeweils zunächst eine Referenzmeßphase durchgeführt, wobei der Schalter S1 für mehrere kurze Zeitabstände von jeweils gleicher Dauer geschlossen wird, so daß sich der Kondensator über die Konstantstromquelle KQ schrittweise auflädt. Dieser Vorgang dauert so lange an, bis die Ladespannung U1 den Wert einer vorbestimmten Referenzspannung Uref erreicht hat. Dieser Zustand wird durch einen Vergleicher VG festgestellt, der dieses Ergebnis an die Steuereinrichtung SE meldet. Damit ist die Referenzmeßphase beendet, und die Anzahl der Schließungen des Schalters S1 sind durch einen Zähler festgehalten. Dieser Zählerstand Nr wird zwischengespeichert und dient für die nachfolgende Erzeugung der analogen Ausgangsspannung Ua, welche am Analogausgang Aa erscheint.

Da der Wert der Referenzspannung Uref ein ganzzahliger Teiler von der durch den digitalen Maximalwert DWmax darstellbaren Maximalspannung Uamax ist, gilt die Beziehung:

$$1. \quad \frac{Uref \times Nw}{Nr} = \frac{Uamax \times DW}{DWmax}$$

Nach Umstellung der Gleichung 1 ergibt sich die zur Erzeugung der analogen Ausgangsspannung notwendige Schrittzahl Nw wie folgt:

$$2. \quad Nw = \frac{Uamax \quad X \quad Nr \quad X \quad DW}{Uref \quad X \quad DWmax}$$

Wenn nun für den Ausdruck: Uamax = k x Uref gesetzt wird, wobei k der Faktor ist, mit dem die Referenzspannung Uref mulitpliziert werden muß,um den mit dem digitalen Maximalwert DWmax darstellbaren maximalen Spannungswert Uamax zu erhalten, so ergibt sich:

$$3. \quad Nw = \frac{k \quad x \quad Nr \quad x \quad DW}{DWmax}$$

Nach dieser Gleichung 3 wird nun die Anzahl der Ladeschritte Nw berechnet, welche notwendig ist, um den Kondensator C so aufzuladen, daß sich eine Ausgangsspannung Ua ergibt, deren Wert dem zu wandelnden Digitalwert DW entspricht. Diese Berechnung wird innerhalb der Steuereinrichtung SE durchgeführt, und es wird beispielsweise ein Zähler mit diesem Wert geladen. Wenn dieser Zähler dann gegen Null gezählt wird, so kann mit dem Zählausgang der Schalter S1 entsprechend oft geschlossen werden. Wenn die entsprechende Anzahl von Zählschritten erreicht worden ist, so hat sich der Kondensator C auf diejenige analoge Ausgangsspannung Ua aufgeladen, die dem zu wandelnden Digitalwert DW entspricht. Von der Steuereinrichtung SE wird dann ein Signal EM abgegeben, welches zur Weiterverarbeitung des Analogwertes dienen kann. Damit kann beispielsweise ein Schalter S3 geschlossen werden, um den Kondensator mit dem Analogausgang Aa zu verbinden. Es kann zweckmäßig sein, den Analogausgang Aa und den Kondensator C durch einen Operationsverstärker OP zu entkoppeln. Zur erwähnen ist noch, daß nach Beenden der Referenzmeßphase oder zu Beginn der eigentlichen Meßphase der Kondensator C entladen werden muß, wozu von der Steuereinrichtung SE ein zweiter Schalter S2 angesteuert wird, worüber der Kondensator C entladen wird.

Aus den zuvor beschriebenen Gleichungen läßt sich entnehmen, daß zur Berechnung der Anzahl von Schließungen des Schalters S1, die zur Bildung der Analogspannung Ua notwendig ist, lediglich Digitalwerte benötigt werden, welche innerhalb der Steuereinrichtung SE vorliegen. Damit spielen die Toleranzen elektrischer Größen wie Stromstärke und Kapazität bei der Erzeugung der analogen Ausgangsspannung Ua keine Rolle.

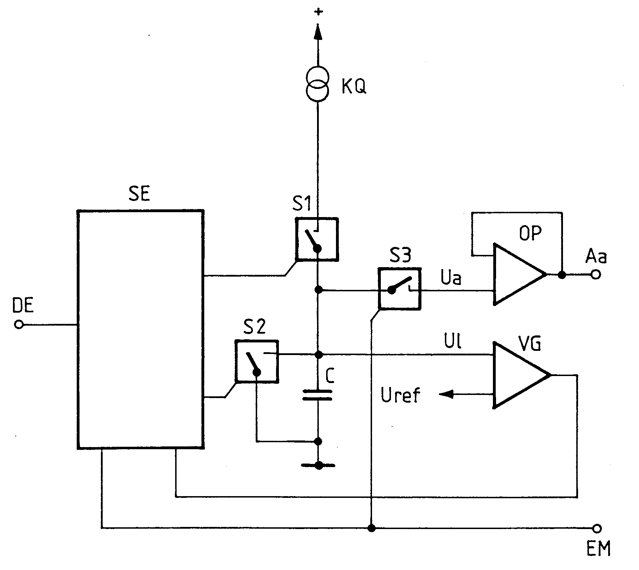

**Patentansprüche**

1. Verfahren zum Betrieb eines Digital-Analog-Wandlers, wobei aus einem Digitalwert eine diesem Wert entsprechende elektrische Spannung erzeugt wird, indem ein Kondensator über einen Schalter aufgeladen wird, der von einem Zähler gesteuert wird,
dadurch gekennzeichnet,
daß an den Kondensator (C) ein Vergleicher (VG) angeschlossen ist, der dessen Ladespannung (U1) mit einer Referenzspannung (Uref) vergleicht, deren Wert ein ganzzahliger Teiler von der durch den digitalen Maximalwert (DWmax) darstellbaren Maximalspannung (Uamax) ist, daß ein erster Schalter (S1) vorgesehen ist, der eine Konstantstromquelle (KQ) mit dem Kondensator (C) verbindet,
daß dieser erste Schalter (S1) während einer ersten Referenzmeßphase so oft oder so lange schlossen wird, bis die Referenzspannung (Uref) erreicht ist, daß die dazu notwendige Schrittzahl (Nr) eines Zählers in einer Steuereinrichtung (SE) gespeichert wird, daß danach ein zweiter Schalter (S2) angesteuert wird, um den Kondensator zu entladen,
und daß der erste Schalter (S1) bei der dann folgenden Meßphase mit einer Schrittzahl (Nw) angesteuert wird, die unter Berücksichtigung des digitalen Maximalwertes (DWmax) und des aus der Referenzspannung (Uref) sich ergebenden Teilerverhältnisses zur Maximalspannung (Uamax) aus dem zu wandelnden Digitalwert (DW) und der zuvor ermittelten Schrittzahl (Nr) von der Steuereinrichtung (SE) errechnet wurde, wobei am Kondensator (C) die gewandelte analoge Ausgangsspannung (Ua) entsteht.

2. Verfahren nach Anspruch 1,

dadurch gekennzeichnet,
daß von der Steuereinrichtung (SE) ein Meßsignal (EM) abgegeben wird, wenn die Meßphase beendet ist.

3. Verfahren nach Anspruch 2,
dadurch gekennzeichnet,
daß ein dritter Schalter (S3) vorgesehen ist, der beim Erscheinen des Meßsignals (EM) geschlossen wird und den Kondensator (C) mit dem Analogausgang (Aa) verbindet.

4. Verfahren nach Anspruch 1,
dadurch gekennzeichnet,
daß der Analogausgang (Aa) durch einen Operationsverstärker (OP) von dem Kondensator (C) entkoppelt ist.